# EUROPÄISCHE PATENTSCHRIFT

(11) **EP 4 081 004 B1**
(45) Veröffentlichungstag und Bekanntmachung des Hinweises auf die Patenterteilung: **28.01.2026**
(21) Anmeldenummer: 22163400.9
(22) Anmeldetag: 22.03.2022
(51) Int. Cl.: H05K 3/32, H01R 12/55, H01R 12/58

(54) **ELEKTRISCHES STECKERMODUL UND VERFAHREN ZUR HERSTELLUNG**
ELECTRICAL CONNECTOR MODULE AND MANUFACTURING METHOD
MODULE DE CONNECTEUR ÉLECTRIQUE ET PROCÉDÉ DE FABRICATION

(30) Priorität: 19.04.2021 DE 102021109720
(43) Veröffentlichungstag der Anmeldung: 26.10.2022
(73) Patentinhaber: Turck Holding GmbH, 58553 Halver (DE)
(72) Erfinder: Gräfenstein, Vitali, 33034 Brakel (DE); Löwen, Nikolaj, 42287 Wuppertal (DE)
(74) Vertreter: DTS Patent- und Rechtsanwälte PartmbB

(56) Entgegenhaltungen:
- EP-B1- 1 111 725
- DE-A1- 102007 039 064
- DE-U1- 9 013 456
- US-A1- 2001 025 964
- US-B1- 6 353 191

## Beschreibung

Die Erfindung bezieht sich auf ein elektrisches Steckermodul mit einer Leiterplatte nach Oberbegriff des Anspruchs 1 und auf ein zugehöriges Herstellverfahren nach dem Oberbegriff des Anspruchs 12.

Leiterplatten und Platinen für elektronische Steckermodule sind bekannt. Bei deren Herstellung werden hierbei elektrische Steckverbindern eingesetzt, die ineinander steckbare Buchsen- und Stift-Stecker aufweisen, die mit der Leiterplatte elektrisch leitend verklebt oder insbesondere verlöten werden. Die hierfür vorgesehenen Buchsen- und Stift-Steckerverbinder sind metallische Elemente deren Lötanschlusselemente gewisse Toleranzen aufweisen, wodurch das präzise Verlöten oder Verkleben erschwert wird und aufwändige Anpassungen und Ausrichtarbeiten erforderlich sind. Je mehr Lötanschlusselemente ein Steckverbinder aufweist, umso problematischer ist es, alle Lötanschlusselemente beim Verbinden mit der Leiterplatte an dem SOLL-Verbindungsort zu platzieren. Im Falle von Steckverbindern in der Gestalt von oberflächenmontierbaren Bauelementen tritt als besonderer Nachteil hinzu, dass häufig die SOLL- Position der äußeren Schutz- oder Befestigungshülse ebenfalls toleranzbedingte Abweichungen aufweist, so dass sich hierdurch die gesamte Abweichung eines einzelnen oder einer Gruppe von Lötanschlusselementen weiter erhöht werden.

Wie bereits von der EP 1 861 898 A1 vorgeschlagen, kann eine Verbesserung erlangt werden, wenn die Steckkontaktteile schwimmend in dem jeweiligen Isolier- oder Befestigungskörper aufgenommen und geführt werden, wobei allerdings eine unmittelbare Korrektur der toleranzbedingten Abweichung nicht erfolgt. Als weiter Lösung wird daher von der EP 2 639 894 A1 vorgeschlagen, die Lötanschlusselemente an einem Toleranzausgleichsstück anzuordnen, welches radial abstehend und als in der Horizontalen verformbares Blech am Ende des Buchsen-Steckerverbinders angeordnet ist. Mittels eines solchen Toleranzausgleichsstücks kann zwar die Positionierung erleichtert werden, aber es verbleibt das Problem, dass alle Lötanschlusselemente vor dem Verlöten in eine SOLL-Position gebracht werden müssen und das radial abstehende Toleranzausgleichsstück erhöht die radiale Abweichung.

Aus der DE 90 13 456 U1 ist eine elektronische Leiterplatte, mit Bohrungen und angrenzenden Lotanschlussbereichen bekannt, wobei im jeweiligen Lotanschlussbereich eine Leitungsbahn angeordnet ist, wobei die Leitungsbahn in den Lotanschlussbereich übergeht. Hierbei ist der angrenzende Lotanschlussbereich einer Bohrung insbesondere als ring- oder kranzförmige um die Bohrung ausgebildet. In eine Bohrung ist ein Führungsstift mit einem Kontakt- und Klemmstifts eingesetzt.

Weiterhin offenbart die US 2001/025964 A1 eine vergleichbare Leiterplatte, welche sowohl Bohrungen mit angrenzendem Lotanschlussbereich aufweist und Lotanschlussbereiche ohne eine solche Bohrung. Hierbei ist auf dem Lotanschlussbereich ein auf der Unterseite flacher Kontakt- und Klemmstift aufgesetzt. Der Kontakt- und Klemmstift umfasst ein Steckerelement, in oder an welchem ein komplementäres Steckergegenelement anbringbar ist.

DE 10 2007 039064 A1 offenbart ein elektrisches Gerät zur Verwendung als Steuergerät für eine Pumpe. Das Gerät weist einen Steckverbinder mit zwei Anschlussstiften und einen Kontaktträger auf, der die Anschlussstifte hält.

Schließlich offenbart die US 6 353 191 B1 ein Ball Grid Array (BGA), das über eine Vielzahl von Lötstiften, die im Bodenelement eingesetzt sind, auf einer Leiterplatte aufgelötet wird.

Von dem beschriebenen Stand der Technik ausgehend liegt der Erfindung die Aufgabe zugrunde, eine Möglichkeit für erleichterte Anbringung von Steckverbindern auf Leiterplatten (Platinen) und Verbesserung der Positionierung von Lötanschlusselementen vorzuschlagen.

Diese Aufgabe wird erfindungsgemäß durch ein elektronisches Steckermodul mit den Merkmalen des Anspruchs 1 gelöst und durch ein zugehöriges Herstellverfahren mit den Merkmalen des Anspruchs 12. Den jeweiligen rückbezogenen Unteransprüchen können die zugehörigen vorteilhaften Ausführungsformen entnommen werden.

Vorliegend werden die Begriffe "Leiterplatte" und "Platine" synonym verwendet, sowie die Begriffe "Hülse" oder "Buchse".

Das erfindungsgemäße elektronische Steckermodul, umfassend ein ein- oder mehrteiliges Gehäuse, sowie mindestens einen Außenstecker, der mittels einer Schutz- und Befestigungshülse oder direkt an dem Gehäuse befestigt ist. Hierbei ist in dem Außenstecker mindestens ein elektrisch leitender Hauptstift angeordnet, der mit einer Leiterplatte (Platine) elektrisch leitend verbunden ist. Dabei umfasst die Leiterplatte eine Tragplatte sowie ein oder mehrere Kontakt- und Klemmstifte und ist nach einer der nachstehenden Ausführungsformen oder einer Kombination hieraus ausgebildet.

Hierbei ist erfindungsgemäß die Leiterplatte eine elektronische Leiterplatte oder Platine, umfassend eine Tragplatte aus einem elektrisch nichtleitenden Material, die im Stand der Technik bekannt sind, so wie elektrische Leitungsbahnen, ein oder mehrere elektronische Bauteile. Die Tragplatte oder das Trägerelement weist hierbei
- mindestens eine Bohrung auf, mit mindestens einem angrenzenden Lotanschlussbereich auf und/oder
- mindestens einen Lotanschlussbereich ohne eine Bohrung auf, wobei zu dem Lotanschlussbereich mindestens eine Leitungsbahn führt und diese Leitungsbahn in den Lotanschlussbereich übergeht. Ist der Lotanschlussbereich angrenzend an eine Bohrung angeordnet, ist dieser insbesondere als ring- oder kranzförmiger Lotanschlussbereich um die Bohrung herum ausgebildet. Weiterhin ist
- in die Bohrung und auf den zugehörigen Lotanschlussbereich ein Führungsstift eines Kontakt- und Klemmstifts ein- bzw. aufgesetzt oder
- auf den Lotanschlussbereich ist ein Kontakt- und Klemmstift flach aufgesetzt, der keinen Führungsstift aufweist.

Hierbei umfasst der Kontakt- und Klemmstift ein Steckerelement, in oder an welchem ein komplementäres Steckergegenelement des Hauptstifts, wie ein Endstift oder eine Endhülse des Hauptstifts des Außensteckers, angebracht ist. Weiterhin ist der Kontakt- und Klemmstifte auf dem jeweiligen Lotanschlussbereich mit mindestens einer Teilfläche verlötet.

Bei einer vorteilhaften Ausführungsform weist der Kontakt- und Klemmstift an einem Ende
- einen Führungsstift auf, welcher mindestens teilweise in der Bohrung der Tragplatte aufgenommen ist und/oder
- eine flache Unterseite auf, die vollflächig auf dem Lotanschlussbereich aufliegt.

Hierbei ist das Steckerelement am gegenüberliegenden Ende als Klemmelement, insbesondere als Klemmbuchse ausgebildet, zur Aufnahme und Verbindung mit einem Hauptstifts oder dessen Endstift.

Der große Vorteil einer solcher Leiterplatte ist, dass die potentielle Kontaktstellen zwischen Leiterplatte und möglichen Außensteckern vorbereitet sind und sehr leicht nutzbar gemacht werden können, wodurch alle nachfolgenden Module in beliebiger Variantenvielfalt einfach und präzise herstellbar sind. Zudem verbessert dieser Kontakt- und Klemmstift als primärer Standardverbinder zur Leiterplatte (Platine), die Verbindung zu allen nachfolgenden Verbindungen.

Bei einer vorteilhaften Ausführungsform wird der Kontakt- und Klemmstift mit dem einen Ende nur teilweise in der Bohrung aufgenommen und das andere Ende, das als Klemmbuchse zur Aufnahme eines Hauptstifts bzw. dessen Endstift, dem freien Verbindungsende ausgebildet ist, ist oberhalb der Tragplatte angeordnet.

Um eine gute Auflage und eine optimale Befestigung bzw. Verlötung zu ermöglichen, sieht eine Ausführungsform vor, dass der äußere Durchmesser und/oder die Schattenfläche der Klemmbuchse größer ist als der äußere Durchmesser und/oder die Schattenfläche des Führungsstifts. Hierdurch wird unterhalb der Klemmbuchse eine Löt- und Auflagefläche ausgebildet, mit welcher der Kontakt- und Klemmstift auf der Tragplatte aufliegt und verlötet wird. Durch diese feste, geführte Positionierung der Kontakt- und Klemmstifte in der jeweiligen Bohrung und Verlötung der Randbereiche, ist stets eine optimale Ausrichtung für den Lötschritt gegeben, wodurch die Qualität der Leiterplatte (Platine) insgesamt verbessert wird. Toleranzschwankungen der Hauptstifte oder von deren Lotfahnen spielen für die optimale elektrische Verbindung zur Leiterplatte keine Rolle mehr und die noch geringfügigen horizontale Lageabweichungen der Hauptstifte werden durch die in der Leiterplatte gehaltenen Klemmhülsen sicher kompensiert.

Vorteilhafterweise weist die innere Oberfläche einer Klemmbuchse mindestens ein nach innen ragendes Schneid- oder Reibelement auf, so dass eine kraftschlüssige und im Idealfall auch eine stoffliche Verbindung zwischen der Klemmhülse und dem Hauptstift geschaffen wird. Besonders vorteilhaft ist ein bis auf kleinere Unterbrechungen umlaufender Schneid- oder Kratzring. Diese Unterbrechungen entstehen beispielweise, wenn die Klemmhülse ein oder mehrere zum freien Ende hin offene Schlitze aufweist, die eine geringfügige, federnde Deformation der Klemmhülse ermöglichen, ohne die Klemmhülse zu beschädigen. Unter dem Begriff "Klemmhülse soll vorliegend jede sinnvolle, passivisch-klemmende Geometrie verstanden werden, wie beispielsweise auch zwei Klemmbacken.

Bei einer weiteren, verbesserten Ausführungsform sind um einzelne Klemmhülsen und/oder eine Gruppe von zwei oder mehr Klemmhülsen ein Dichtelement, wie insbesondere ein Dichtrahmen oder -ring angeordnet, wobei das Dichteelement vorteilhafterweise auf der Tragplatte aufgeklebt ist.

Eine weitere, verbesserte Aufführungsform sieht vor, dass mindestens ein Kontakt- und Klemmstift, insbesondere eine Gruppe von Kontakt- und Klemmstiften, Teil eines Verbindungselementes und mit diesem fest verbunden ist, insbesondere kraft- und/oder formschlüssig verbunden, verschweißt, eingegossen oder verklebt ist. Hierbei umfasst das Verbindungselement ein elektrisch nichtleitendes Dichtmaterial bzw. wird zum großen Teil aus diesem Dichtmaterial als monolithischer Grund- oder Hauptkörper gebildet. Das Dichtmaterial umschließt den mindestens einen Kontakt- und Klemmstift oder die Gruppe der Kontakt- und Klemmstiften, wozu ein einzelner Kontakt- und Klemmstift oder eine Gruppe von Kontakt- und Klemmstiften in einer Öffnungen, Bohrung oder Kanal im Dichtmaterial angeordnet sind und von diesem Dichtmaterial umschlossen werden. Die Kontakt- und Klemmstifte einer Gruppe von Kontakt- und Klemmstiften werden insbesondere dadurch bestimmt, dass diese Kontakt- und Klemmstift alle einem einzelnen zu verbindenden Außenstecker funktional zugeordnet sind, und wobei die Anzahl der Kontakt- und Klemmstifte vorteilhafterweise der Zahl der maximal möglichen Verbindungsmöglichkeiten entspricht, d.h. für den Fall einer vollständigen Belegung aller elektrischen Verbindungsmöglichkeiten des Außensteckers mit der Leiterplatte.

Eine verbesserte Ausführungsform sieht vor, dass die Lage- und Ausrichtung der Kontakt- und Klemmstifte in dem Verbindungselement derart ist, dass die Kontakt- und Klemmstifte Auflageflächen aufweisen, insbesondere unterhalb der Steckhülsen, die als Lötflächen fungieren und alle Auflageflächen der Kontakt- und Klemmstifte eines Verbindungselements mit der Unterseite des jeweiligen Verbindungselementes, hier dem Dichtmaterial, eine gemeinsame Kontakt- und Auflagefläche bilden.

Das vorstehend beschriebene Verbindungselement ist vorteilhafterweise auf der Tragplatte befestigt, insbesondere durch Verkleben, Anhaften, Verrastung und/oder Verklemmung, zusätzlich zu den Lötverbindungen der Kontakt- und Klemmstifte mit der Leiterplatte.

Bei einer Ausführungsform des Steckermoduls weist dieses zwischen der Tragplatte und dem Gehäuse mindestens ein Innenraum auf, der mindestens teilweise mit einem Gussmaterial, das ein elektrisch nichtleitendes Gussmaterial ist, wie beispielsweise ein Akrylharz mindestens teilweise gefüllt ist. Als Gussmaterial können in Abhängigkeit von den Wechselwirkungen mit den umflossenen Bauteilen und -elementen alle üblichen Materialien verwendet werden. Vorteilhafterweise weist die Schutz- und Befestigungshülse oder der Außenstecker mindestens eine innere Anschlagkante auf, welche an einer inneren Oberfläche des Gehäuses anliegt und dies abdichtet, wobei eine Verbesserung darin besteht, im Bereich der Anschlagkante und der Anlagefläche mit der inneren Oberfläche, eine Dichtung oder Dichtungsmaterial vorzusehen.

Bei dem erfindungsgemäßen Herstellverfahren von Steckermodulen nach einem oder mehreren der vorherigen Ausführungsformen sind insbesondere die folgenden Schritte umfasst.
- Bereitstellung von Tragplatten mit mindestens einer Bohrung und/oder mindestens einem Lotanschlussbereichen für einen Kontakt- und Klemmstift, wobei die Tragplatte in der Regel bereits mit allen Leitungsbahnen und Funktionsbausteinen und - elementen belegt ist, so dass die nachfolgenden Schritte vorteilhafterweise die abschließenden Fertigungsschritte der eigentlichen Leiterplatte darstellen,
- ein- oder aufsetzen von mindestens einem Kontakt- und Klemmstift in die mindestens Bohrung und/oder den Lotanschlussbereich,
- herstellen einer Befestigung und elektrisch leitenden Verbindung des mindestens einen Kontakt- und Klemmstift oder der mindestens einen Gruppe von Kontakt- und Klemmstiften mit der Tragplatte, insbesondere durch Verlöten und
- aufstecken der Tragplatte beziehungsweise der Leiterplatte auf mindestens einen Hauptstift eines in einem Gehäuse eingefügten und gehaltenen Außensteckers.

Bei einer alternativen Ausführungsform des Herstellverfahrens, wird vor dem Aufstecken der Tragplatte bzw. der Leiterplatte auf den mindestens einen Hauptstift eines in einem Gehäuse eingefügten und gehaltenen Außensteckers, ein Dichtelement um den mindestens einen Kontakt- und Klemmstift und/oder die mindestens eine Gruppe der Kontakt- und Klemmstiften gelegt. Hierbei ist das Dichtelement insbesondere eines, welches sowohl jeden Kontakt- und Klemmstift einer Gruppe von Kontakt- und Klemmstiften einzeln und insbesondere die jeweilige Gruppe der Kontakt- und Klemmstifte insgesamt umschließt.

Bei einer vorteilhaften Ausführungsform ist der mindestens eine Kontakt- und Klemmstift oder die mindestens eine Gruppe an Kontakt- und Klemmstifte eine Komponente eines Verbindungselementes, welches weiterhin mindestens ein eine Öffnung aufweisendes Dichtmaterial umfasst oder zu großen Anteilen hieraus gebildet wird. Hierbei wird einer oder mehrere Kontakt- und Klemmstift mindestens teilweise in mindestens einer Öffnung des Dichtmaterials angeordnet, bevor diese auf der Tragplatte befestigt wird.

Hierbei soll unter Öffnung in Dichtmaterial insbesondere jeder Kanal oder Bohrung verstanden werden, der zum einen den Kontakt- und Klemmstift umschließt und weiterhin das direkte Einführen eines Gegensteckers zulässt. Das Verbindungselement, wird bei der Fertigung also als vorgefertigter kleiner Zwischenstecker mit allen nötigen, insbesondere der max. Anzahl an Kontakt- und Klemmstift bereitgestellt und in die zugehörigen Bohrungen (Gruppe von Bohrungen) eingesetzt oder auf die zugehörigen Lotanschlussbereiche aufgesetzt. Anschließend werden die Kontakt- und Klemmstifte über die Auflageflächen verlötet, was über die Rückseite der Tragplatte erfolgen kann. Hierbei ist keine oder nur eine geringfügige Ausrichtung erforderlich, wodurch der Fertigungsprozess der Steckermodule insgesamt sehr beschleunigt wird.

Alle Angaben zur Orientierung von Elementen, wie bspw. "Oberseite" oder "Unterseite", beschreiben eine Lage der Leiterplatte oder des Steckermoduls, bei denen ein Außenstecker vertikal von oben aufgesteckt bzw. angebracht werden kann, also die Leiterplatte wie in den Figuren dargestellt und beschrieben, horizontal ausgerichtet ist und die Klemmbuchsen der Kontakt- und Klemmstifte vertikal nach oben weisen. Es ist für den Fachmann unmittelbar ersichtlich, dass derartige Angaben zur geometrischen Orientierung nur der beispielhaften Beschreibung dient und keinerlei Einschränkung für jedwede finale Einbaulage und Ausrichtung bedeutet.

Weiterhin wird das freie, untere Ende des Hauptsteckers vorrangig als Endstift beschrieben, der in einer von der Leiterplatte getragenen Klemmhülse aufgenommen wird, was zweifelsfrei eine sehr vorteilhafte Ausführungsform darstellt. Es ist dem Fachmann allerdings unmittelbar einsichtig, dass dieses Prinzip invertierbar ist, indem das untere freie Ende des Hauptsteckers als Endhülse/-buchse ausgeführt ist und statt der Klemmhülse der Leiterplatte mindestens ein Gegenstift/-stecker vorgesehen ist, der über die Leiterplatte hinausragt und von dieser Endhülse des Hauptstiftes in analoger Weise aufgenommen wird.

Die Erfindung wird im Folgenden anhand der Figuren an Ausführungsbeispielen näher erläutert. Es zeigt
- Fig. 1: das Steckermodul in einer Schnittdarstellung,
- Fig. 2a, b, c: Detailansichten der Platine als Schnittdarstellung mit unterschiedlichen Ausführungsformen der Kontakt- und Klemmstifte,
- Fig. 3: das Steckermodul gem. Figur 1 in einer Ausführungsform,
- Fig. 4: in einer perspektivischen Darstellung unterschiedliche Dichtelemente,
- Fig. 5a, b, c, d: in einer perspektivischen Darstellung unterschiedliche Kontakt- und Klemmstifte umfassende Verbindungselemente,
- Fig. 6: ein zu den Figuren 1 oder 3 analoges Steckermodul in einer verbesserten Ausführungsform,
- Fig. 7: eine schematische Darstellung eines Fertigungsverfahrens des Steckermoduls nach Figur 1 und
- Fig. 8: einen ersten Fertigungsschritt für eine Ausführungsform der Platine.

Für gleiche oder gleich wirkende Elemente der Erfindung werden in den Figuren identische Bezugszeichen verwendet. Ferner werden der Übersichtlichkeit halber nur Bezugszeichen in den einzelnen Figuren dargestellt, die für die Beschreibung der jeweiligen Figur erforderlich sind. Auch ist die Erfindung in den Figuren nur als schematische Ansicht zur Erläuterung bspw. der Arbeitsweise dargestellt, und die Figuren dienen nur der Erläuterung des grundlegenden Prinzips der Erfindung. Aus Gründen der Übersichtlichkeit ist darauf verzichtet worden, alle Bestandteile insbesondere der Leiterplatte oder Platine zu zeigen, welche in der Regel ein- oder beidseitig mit einer Vielzahl gedruckten oder gelöteten Leitungsbahnen belegt ist und unterschiedlichste elektronische Bauelementen, Funktionsbausteinen etc. aufweist.

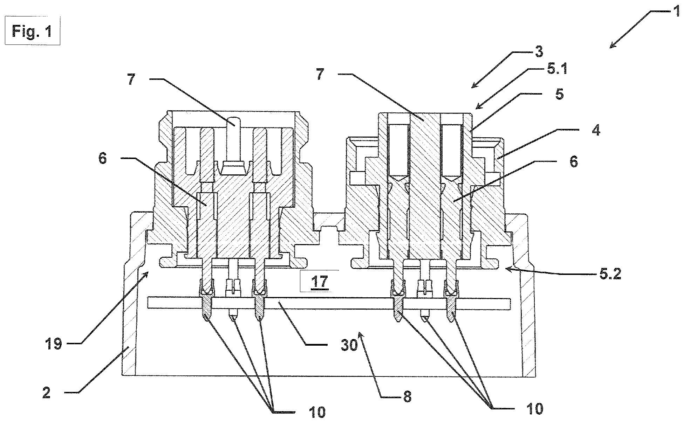

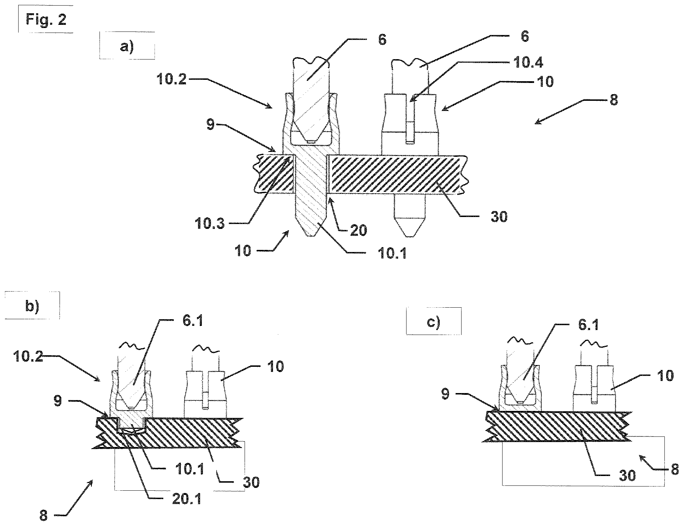

Die Figur 1 zeigt das Steckermodul 1 mit zwei Außensteckern 3, also Außenstecker, die bedarfsweise von einem Nutzer mit einem Gegenstecker verbunden werden können. Die Außenstecker 3 sind in bekannter Weise in einem Gehäuse 2 des Steckermoduls 1 aufgenommen, wozu diese durch Montageöffnungen 19 hindurchgesteckt und mit diesen verrastet sind. Der Außenstecker 3 ist zweiteilig aufgebaut und weist einen äußeren Schutz- und Befestigungskörper 4 auf und einen darin gehaltenen Innenkörper 5, in dem mehrere elektrisch leitende Hauptstifte 6 angeordnet sind. Bei dem links dargestellten Außenstecker 3 sind die Hauptstifte 6 an ihrem äußeren Ende 5.1 des Innenkörpers 5 als Kontaktbolzen ausgeführt und bei dem linken Außenstecker 3 als Kontakthülse. Weiterhin ist jeweils ein zentraler, elektrisch nichtleitender Führungsbolzen 7 vorgesehen. Am inneren Ende 5.2 des Innenkörpers 5 sind die Hauptstifte 6 mit einer Kontakt- und Klemmstifte 10 umfassenden Platine 8 verbunden. Diese Kontakt- und Klemmstifte 10 sind in der Tragplatte 30 der Platine 10 eingelötet, wie nachfolgend zu Figur 2 noch im Detail ausgeführt wird.

Bei einer nicht dargestellten Ausführungsform wird der Außenstecker 3 von außen zusätzlich befestigt oder gekontert, insbesondere mit einer Überwurfmutter. Weiterhin können Dichtungen zwischen Flanschen des Innenkörpers 5 oder dem Schutz- und Befestigungskörper 4 und einer jeweiligen Gegen- oder Anlagefläche vorgesehen werden, die vorliegend nicht dargestellt sind.

In der Figur 2a ist eine Ausführungsform der Platine 8 gezeigt, bei der beispielhaft zwei Kontakt- und Klemmstifte 10 durch Bohrungen 20, die als Durchgangsbohrungen ausgeführt sind, durch die Tragplatte 30 hindurchgeführt sind. Die Platine 8 kann weitere bekannte Platinenkomponenten, Leitungsbahnen, etc. aufweisen, die vorliegend nicht dargestellt sind. Die Kontakt- und Klemmstifte 10 weist am oberen Ende, die der Unterseite 5.2 des Innenkörpers 5 zugewandt ist, eine Klemmbuchse 10.2 auf und an ihrem anderen freien Ende, ist der Kontakt- und Klemmstift 10 als Führungsstift 10.1 ausgebildet, der teilweise durch die Tragplatte 30 der Platine 8 geführt ist und diese mit einer Teillänge überragt. Unterhalb des Klemmbuchse 10.2, am Übergang zum Führungsstift 10.1, der einen geringeren Durchmesser aufweist, ist eine Löt- und Auflagefläche 10.3 ausgebildet, die in einem Bereich auf der Tragplatte 30 aufliegt, der mindestens teilweise dem Lotanschlussbereich 9 entspricht und mit dieser verlötet ist. Die Klemmbuchse 10.2 weist in der gezeigten Ausführungsform mindestens eine Einschnürung auf, um eine Klemmung mit dem Endstift 6.1 des Hauptstifts 6 herzustellen und weiterhin mindestens einen vertikalen Dehnschlitz 10.4, um eine geringfügige Bewegung und Deformation für die Klemmung zuzulassen. Bei der Ausführungsform nach Figur 2b, einer Verbesserung der Ausführung nach Figur 2a, ist die Tragplatte 30 nicht mit einer Durchgangsbohrung durchbohrt, sondern weist nur eine Sack- oder Vertiefungsbohrung 20.1 auf. Das freie Ende des Kontakt- und Klemmstifts 10 weist eine Länge auf, die geringfügig kürzer ist als die Tiefe der Vertiefungsbohrung 20.1 und ist in dieser eingeführt. Die Anlage und Verlötung im Lotanschlussbereich 9 ist analog. Durch diese Ausführungsform bleibt die gesamte Unterseite der Leiterplatte ungestört und kann somit vollständig für beispielsweise die Anordnung von Leitungsbahnen, Funktionselemente oder sonstige Elemente genutzt werden. In der Vertiefungsbohrung 20.1 kann ein Harz- oder Klebermaterial vorgesehen sein, nicht dargestellt, um die Festigkeit zu erhöhen. Schließlich zeigt Figur 2c eine Ausführungsform, bei der der Kontakt- und Klemmstift 10 unterhalb des hülsenartigen Steckerelementes flach ausgeführt ist, so dass die vollständige Unterseite der Klemmhülse 10.2 auf in dem Lotanschlussbereich 9 aufliegt und angelötet ist.

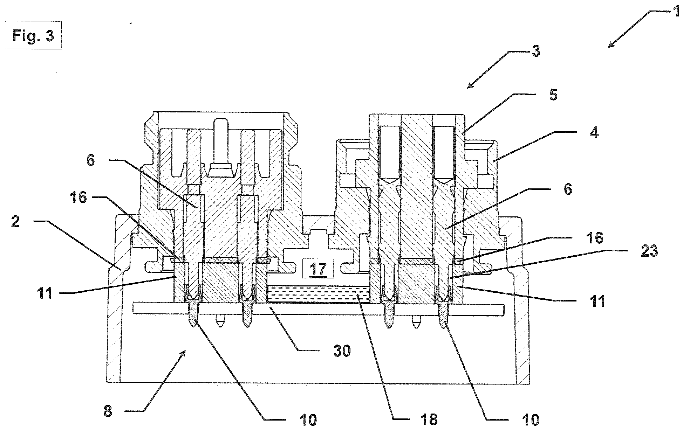

In der Schnittdarstellung der Figur 3, ist ein Steckermodul 1 gezeigt, das analog zu dem der Figur 1 zwei Außenstecker 3 zeigt, die mit einer Kontakt- und Klemmstifte 10 umfassenden Platine 8 über eben diese Kontakt- und Klemmstifte 10 mittels einer Steck-Hülsen-Verbindung verbunden sind. Zum Schutz der inneren Steckerverbindungen ist zwischen dem unteren Ende 5.2 des Innenkörpers 5 und der Oberseite der Tragplatte 30 jeweils ein Dichtelement 11 angeordnet, welches die einzelnen Kontakt- und Klemmstifte 10 und die Gruppen der Kontakt- und Klemmstiften 10 von außen umschließt. Weiterhin ist zu erkennen, dass in dem Innenraum 17 zwischen Gehäuses 2 und Tragplatte 30 ein Gussmaterial 18 eingebracht ist, das den Innenraum 17 teilweise ausfüllt. An der Oberseite der Verbindungselemente 13 ist jeweils ein Überschnitt 16 zu erkennen, der durch die Stauchung des Dichtmaterials 15 gebildet wurde. Die Klemmbuchsen 10.2 enden mit ihrer Oberkante gut geschützt vor Umwelteinflüssen in der Mitte der Öffnungen 23 des Dichtmaterials 15.

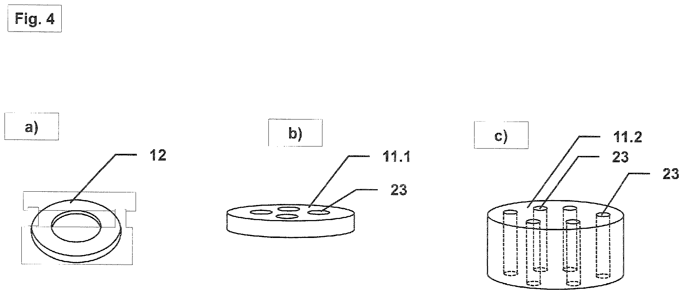

Diese Dichtelemente können, wie in Figur 4c dargestellt, auch als Dichtring 12 ausgebildet sein, der eine Gruppe von Kontakt- und Klemmstiften 10, die einem Außenstecker 3 zugeordnet sind, umschließt. Die Varianten der Dichtelemente 11.1 und 11.2 gemäß den Figuren 4b und 4c zeigen Dichtelemente, wie sie bei dem Steckermodul nach Figur 3 vorgesehen wurden. Diese Dichtelemente werden bei der Herstellung des Steckermoduls 1 entweder auf die Platine 8 aufgelegt oder aufgeklebt, bevor diese mit den Stiftenden 6.1 der Hauptstiften 6 zusammengefügt werden. Alternativ werden diese vor dem Verbinden mit der Platine 8 mit den Öffnungen 23 um bzw. über die Endstifte 6.1 der Hauptstifte 6 am inneren Ende eines Außensteckers 3 gelegt.

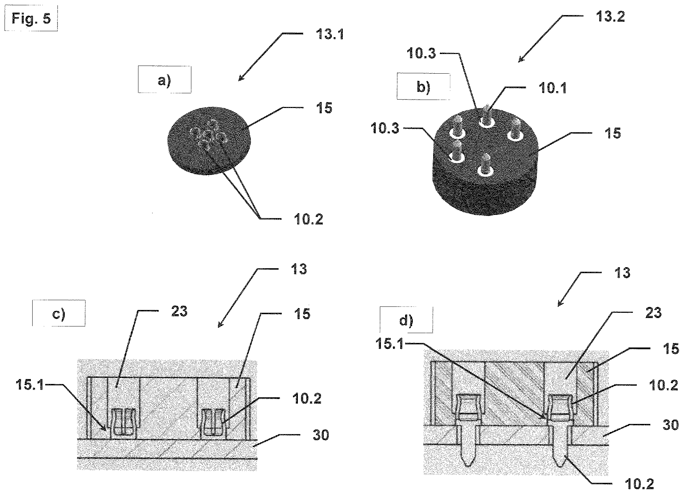

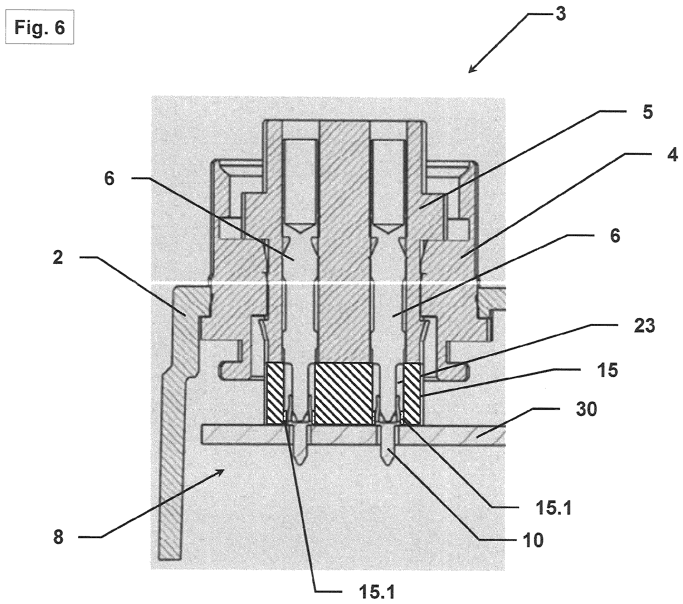

Bei den in Figur 5a-d dargestellten Varianten stellen die Kontakt- und Klemmstift 10 und die Dichtung ein Verbindungselement 13 dar, das als ein Bauteil aus im Wesentlichen einem Dichtmaterial 15 und den Kontakt- und Klemmstiften 10 gebildet wird. Hierbei sind die Kontakt- und Klemmstifte 10 in den Öffnungen des Dichtmaterials 15 in geeigneter Weise im angrenzenden Haltebereich 15.1 eingeklebt, eingegossen, eingepresst oder in sonstiger Weise befestigt. Die Figur 5a zeigt die Oberseite 13.1 des Verbindungselementes 13 und Figur 5b die Unterseite 13.2 des Verbindungselementes 13, aus welcher die freien Enden der Kontakt- und Klemmstifte 10 herausragen. Bei der flachen Ausführungsvariante nach Figur 5a ragen sowohl die Klemmbuchsen 10.2 also auch die freien Enden (nicht dargestellt) der Kontakt- und Klemmstifte 10 aus dem Dichtmaterial 15 heraus. Unterschiedlich hierzu sind die Kontakt- und Klemmstifte 10 gemäß der Ausführung in der Figur 5b derart in den Öffnungen des Dichtmaterials 15 angeordnet, dass die Auflagefläche, 10.3 der Kontakt- und Klemmstift 10 mit der Unterseite 13.2 eine geschlossene Fläche bilden. In der Einbaulage liegt die Unterseite 13.2 und damit auch die Auflageflächen 10.3 auf der Tragplatte 30 auf. Die Klemmbuchsen 10.2 überragen das Dichtmaterial 15 nicht, wie auch in der Figur 6 dargestellt ist, sondern sind in der vertikalen Öffnung 23 des Dichtmaterials 10 innenliegend und somit gut geschützt.

Die Figuren 5c und 5d zeigen auf der Tragplatte 30 aufgeklebte und aufgelötete Verbindungselemente 13, wobei die Figur 5c ein Verbindungselement 13 zeigt, in welchem Kontakt- und Klemmstifte 10 im Haltebereich 15.1 verklebt sind, die denen der Figur 2c entsprechen. Bei den Verbindungselementen 13 der Figur 5d ist der analoge Aufbau zur Figur 5c gezeigt, wobei die beiden dargestellten und im Haltebereich 15.1 klemmend gehaltenen Kontakt- und Klemmstifte 10 der Ausführungsform gemäß der Figur 2a entsprechen, so dass das oben genannte in analoger Weise gilt.

Der Aufbau gemäß der Figur 6 ist vergleichbar der Figur 3, wobei vorliegend die Platine 8 mit Verbindungselementen 13 belegt ist, die analog der Figur 5b und 5d aufgebaut und angeordnet sind. Die Verbindungselemente 13 sind auf der Unterseite mit der Tragplatte 30 verklebt und/oder über die Auflageflächen 10.3 der Kontakt- und Klemmstift 10 verlötet.

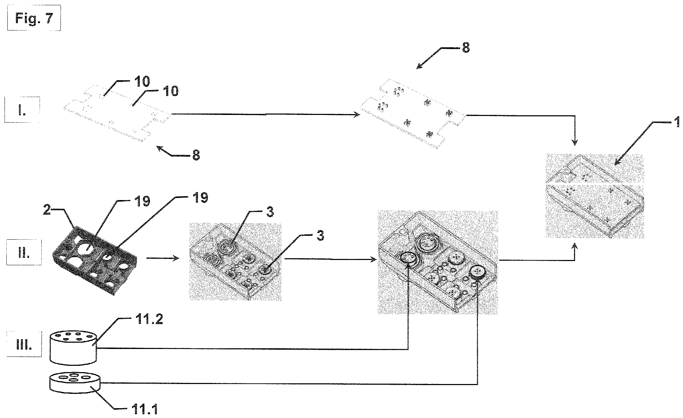

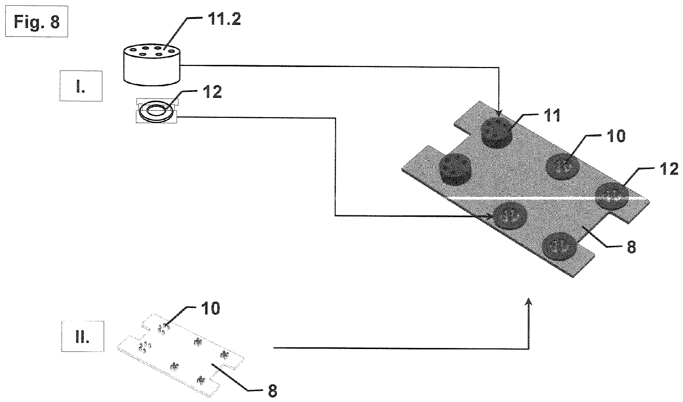

Der besondere Vorteil dieser Erfindung liegt in der einfachen Montage der Platine 8 und der Steckermodule 1, wie in den Figuren 7 und 8 noch kurz erläutert werden soll. Wurde bisher der Hauptstift bzw. ein oder mehrere Elemente des Hauptstifts eines Außensteckers direkt mit eine Leiterplatte verlötet, zeigt die Abfolge nach Pfad I. der Figur 7, dass die Trägerplatte 30 separat mit den Kontakt- und Klemmstiften 10 bestückt wird, und zwar unabhängig von einer speziellen Ausführungsform oder Variante des eigentlichen Steckermoduls 1 und den vorzusehenden Außenstecken 3. Es werden in der Regel alle maximal möglichen Löt- und Kontaktplätze für Außenstecker 3 mit Kontakt- und Klemmstiften 10 belegt und diese verlötet. Der Pfad II. der Figur 7 zeigt links ein monolithisches Gehäuse 2 mit den Öffnungen 19 für die Außenstecker 3. Im nachfolgenden Schritt sind die unterschiedlichen Außenstecker 3 eingepresst und anschließend mit Dichtelementen 11, 12, wie beispielsweise zur Figur 4 beschrieben und gezeigt.

Abschließend erfolgt nur noch das mechanische Zusammenfügen, ein Zusammenpressen, der Platine 8 mit den Endstiften 6.1 der Hauptstifte 6, die durch die SteckerBuchsen-Geometrie einen Toleranzausgleich ohne gesonderte Nachbearbeitung oder Justierung ermöglichen. Zudem ist ein aufwändiges Ausrichten und Halten von Lötfahnen nicht mehr nötig und es müssen auch keine Bauteile gegen schädlichen Wärmeeintrag bei einem finalen Lötprozess geschützt werden.

Die Figur 8 zeigt eine verbesserte Variante, bei der die Fertigung weiter vereinfacht wurde, indem im Pfad I. der Figur 7 nun auch die Dichtelemente 11, 12 vor dem finalen Zusammenfügen auf die Tragplatte 30 aufgeklebt werden. Dieser Arbeitsschritt kann vollständig unabhängig dem finalen Zusammenfügen vorbereitet werden.

Nicht dargestellt, aber in analoger Weise, erfolgt die Fertigung einer Platine 8, die mit Verbindungselementen 13 gemäß der Figur 5 bestückt und vorgefertigt ist. Diese werden ebenfalls vorbereitend auf die Leiterplatte 30 aufgeklebt und/oder aufgelötet. Hierbei ergibt sich ein weiterer Fertigungsvorteil, weil bereits eine Gruppe von Kontakt- und Klemmstiften in ihrer Lage zueinander festgelegt sind.

Diese durchgängige Stecker-Hülsen-Verbindungen eines Hauptstiftes, dessen Endstift oder -hülse in einen von einer Leiterplatte getragenen Kontakt- und Klemmstift, weist nur geringe horizontale Toleranzabweichungen auf, die durch die jeweiligen konischen Hülsen und entsprechend geformten Stiftköpfe, die in der Regel konisch oder abgerundet enden, effektiv beim Ineinanderfügen kompensieren werden.

Vorliegend sind unterschiedliche Ausführungsformen unterscheiden, wobei dem Fachmann hiermit nahegelegt wird, die einzelnen Elemente oder Kombinationen hiervon, soweit sie sich nicht gegenseitig ausschließen, bedarfsweise zu kombinieren, zu vervielfältigen oder teilweise nicht vorzusehen.

### Bezugszeichenliste

- 1: Steckermodul
- 2: Gehäuse
- 3: Außenstecker
- 4: Schutz- und Befestigungshülse
- 5: Innenkörper
- 6: Hauptstift
6.1 Endstift
- 7: Führungsbolzen/-element
- 8: Leiterplatte (Platine)
- 9: Lötanschlussbereich
- 10: Kontakt- und Klemmstift (in der Patine)
10.1 Führungsstift
10.2 Klemmbuchse
10.3 Löt -und Auflagefläche
10.4 Dehnschlitz
- 11: Dichtelement
11.1 Dichtelement
11.2 Dichtelement
- 12: Dichtring
- 13: Dicht- und Verbindungselement
13.1 Klemmverbindungselement
13.2 Steckverbindungselement
- 14: Zwischenstift (in der Dichtelement)
14.1 Klemmzwischenstift
14.2 Steckzwischenstift
- 15: Dichtmaterial
15.1 Haltebereich
- 16: Überschnitt
- 17: Innenraum
- 18: Gussmaterial
- 19: Aussparung
- 20: Bohrung (in der Platine zur Aufnahme von 10)

- 23: Öffnung
- 30: Tragplatte

## Patentansprüche

1. Elektronisches Steckermodul (1), umfassend ein ein- oder mehrteiliges Gehäuse (2), mindestens einen Außenstecker (3), der mittels einer Schutz- und Befestigungshülse (4) oder direkt an dem Gehäuse (2) befestigt ist, wobei in dem mindestens einen Außenstecker (3) mindestens ein elektrisch leitender Hauptstift (6) angeordnet ist, welcher mit einer elektronischen Leiterplatte (8) elektrisch leitend verbunden ist, wobei die Leiterplatte (8)
eine Tragplatte (30) und Kontakt- und Klemmstifte (10) umfasst, und wobei
- die Tragplatte (30) aus einem elektrisch nicht leitenden Material gebildet ist, elektrische Leitungsbahnen und mindestens ein elektronisches Bauteil/- komponente umfasst, und wobei die Tragplatte (30)
- mindestens eine Bohrung (20) mit mindestens einem angrenzenden Lotanschlussbereich (9) aufweist und/oder
- mindestens einen Lotanschlussbereich (9) ohne eine Bohrung (20) aufweist, wobei zu dem mindestens einen Lotanschlussbereich (9) mindestens eine Leitungsbahn führt und diese Leitungsbahn in den Lotanschlussbereich übergeht, wobei der angrenzende Lotanschlussbereich (9) einer Bohrung (20) insbesondere als ring- oder kranzförmiger Lotanschlussbereich um die Bohrung (20) herum ausgebildet ist, wobei
- in die mindestens eine Bohrung (20) ein Führungsstift (10.1) eines einen Führungsstift (10.1) aufweisenden Kontakt- und Klemmstifts (10) eingesetzt ist oder
- auf den Lotanschlussbereich (9) ein keinen Führungsstift (10.1) aufweisender Kontakt- und Klemmstift (10) aufgesetzt ist, wobei der Kontakt- und Klemmstift (10) ein Steckerelement umfasst, in oder an welchem ein komplementäres Steckergegenelement des Hauptstifts (6), wie ein Endstift (6.1) oder eine Endhülse des Hauptstifts (6), angebracht ist,
und wobei der mindestens eine Kontakt- und Klemmstift (10) auf dem Lotanschlussbereich (9) mit mindestens einer Teilfläche verlötet ist , wobei bei der Leiterplatte (8) der Kontakt- und Klemmstift (10) an einem Ende
- einen Führungsstift (10.1) aufweist, welcher mindestens teilweise in der Bohrung (20) aufgenommen ist und/oder
- eine flache Unterseite aufweist, die vollflächig auf dem Lotanschlussbereich (9) aufliegt, und wobei das Steckerelement am gegenüberliegenden Ende als Klemmelement zur Aufnahme eines Hauptstifts (6) oder dessen Endstift (6.1) ausgebildet ist.

2. Steckermodul nach einem der vorherigen Ansprüche, **dadurch**
**gekennzeichnet, dass** bei der Leiterplatte (8) der äußere Durchmesser und/oder die Schattenfläche der Klemmbuchse (10.2) größer ist als der äußere Durchmesser und/oder die Schattenfläche des Führungsstifts (10.1), wodurch unterhalb der Klemmbuchse (10.2) eine Löt- und Auflagefläche (10.3) ausgebildet ist, mit welcher der Kontakt- und Klemmstift (10) im Lotanschlussbereich (9) auf der Tragplatte (30) aufliegt und mit dieser verlötet ist.

3. Steckermodul nach einem der vorherigen Ansprüche, **dadurch**
**gekennzeichnet, dass** bei der Leiterplatte (8) die innere Oberfläche der Klemmbuchse (10.2) mindestens ein nach innen ragendes Schneid- oder Reibelement aufweist.

4. Steckermodul nach einem der vorherigen Ansprüche, **dadurch**
**gekennzeichnet, dass** bei der Leiterplatte (8) die Klemmhülse (10.2) durch mindestens einen zum freien Ende der Klemmhülse (10.2) hin offenen Schlitz (10.4) aufweist.

5. Steckermodul nach einem der vorherigen Ansprüche, **dadurch**
**gekennzeichnet, dass** bei der Leiterplatte (8) die Bohrung (20) in der Tragplatte (30) als Sackbohrung ausgeführt ist, die die Tragplatte (30) nur an der die Klemmbuchse (10.2) tragenden Oberseite durchbricht, wobei der Führungsstift (10.2) des Kontakt- und Klemmstifts (10) vollständig in dieser Bohrung (20), die als Sackbohrung ausgeführt ist, aufgenommen ist, und wobei insbesondere das freie Ende (6.1) mindestens mit einer Teillänge in der Bohrung (20) eingeklebt oder eingegossen ist.

6. Steckermodul nach einem der vorherigen Ansprüche, **dadurch gekennzeichnet, dass** bei der Leiterplatte (8) um eine Klemmhülse (10.2) und/oder eine Gruppe von mindestens zwei Klemmhülsen (10.2) ein Dichtelement (11) oder ein Dichtring (12) angeordnet ist, insbesondere ein aufgeklebtes Dichtelement (11) oder Dichtring (12).

7. Steckermodul nach einem der vorherigen Ansprüche, **dadurch gekennzeichnet, dass** bei der Leiterplatte (8) der mindestens eine Kontakt- und Klemmstift (10) oder eine Gruppe von Kontakt- und Klemmstift (10) Teil eines Verbindungselementes (13) ist, mit welchem dieser fest verbunden ist, insbesondere kraft- und/oder formschlüssig, verklebt oder vergossen ist, und wobei das Verbindungselement (13) ein Dichtmaterial (15) umfasst, welches den mindestens einen Kontakt- und Klemmstift (10) einzeln oder die mindestens eine Gruppe der Kontakt- und Klemmstift (10) umschließt und wobei das Dichtmaterial (15) mindestens eine Öffnungen umfasst, in welchen der mindestens eine Kontakt- und Klemmstift (10) oder die mindestens eine Gruppe der Kontakt- und Klemmstift (10) angeordnet sind.

8. Steckermodul nach Anspruch 7, **dadurch gekennzeichnet, dass** bei der Leiterplatte (8) die Kontakt- und Klemmstift (10) Auflageflächen (10.3) aufweisen, die als Lötflächen fungieren und alle Auflageflächen (10.3) der Kontakt- und Klemmstift (10) eines Verbindungselements (13) mit der Unterseite des jeweiligen Verbindungselementes (13) eine gemeinsame Fläche bilden.

9. Steckermodul nach einem der Ansprüche 7 oder 8, **dadurch gekennzeichnet, dass** bei der Leiterplatte (8) das Verbindungselement (13) auf die Tragplatte (30) aufgeklebt und/oder über Lötverbindungen der Kontakt- und Klemmstift (10) verbunden ist.

10. Steckermodul nach einem der vorherigen Ansprüche, **dadurch gekennzeichnet, dass** zwischen der Tragplatte (30) und dem Gehäuse (2) mindestens ein Innenraum (17) ausgebildet ist, welcher mit einem Gussmaterial (18) mindestens teilweise gefüllt ist.

11. Steckermodul nach einem der Ansprüche 9 oder 10, **dadurch**
**gekennzeichnet, dass** die Schutz- und Befestigungshülse (4) oder der Außenstecker (3) mindestens eine innere Anschlagkante (4.1 21, 22) aufweist, welche an einer inneren Oberfläche des Gehäuses (2) anliegt.

12. Herstellverfahren für ein elektronisches Steckermodul nach einem der Ansprüche 1 bis 11, umfassend die Schritte:
- Bereitstellung von Tragplatten (30) mit mindestens einer Bohrung (20) und/oder Lotanschlussbereichen (9) für einen Kontakt- und Klemmstift (10),
- auf- und/oder einsetzen von mindestens einem Kontakt- und Klemmstift (10) in die mindestens eine Bohrung (20) und/oder den mindestens einen Lotanschlussbereich (9),
- herstellen einer Befestigung und elektrisch leitende Verbindung des mindestens einen Kontakt- und Klemmstifts (10) mit der Tragplatte (30), insbesondere durch Verlöten und
- Aufstecken der Tragplatte (30) auf mindestens einen Hauptstift (6) eines in einem Gehäuse (2) eingefügten und gehaltenen Außensteckers (3).

13. Herstellverfahren nach Anspruch 12, **dadurch gekennzeichnet, dass** vor dem Aufstecken der Tragplatte (30) auf den mindestens einen Hauptstift (6) eines in einem Gehäuse (2) eingefügten und gehaltenen Außenstecker (3), ein Dichtelement (11, 12) um den mindestens einen Kontakt- und Klemmstift (10) oder die mindestens eine Gruppe der Kontakt- und Klemmstiften (10) gelegt wird, insbesondere ein Dichtelement (11), welches sowohl jeden Kontakt- und Klemmstift (10) einer Gruppe von Kontakt- und Klemmstiften (10) einzeln und die jeweilige Gruppe der Kontakt- und Klemmstiften (10) insgesamt umschließt.

14. Herstellverfahren nach Anspruch 13, **dadurch gekennzeichnet, dass** der mindestens eine Kontakt- und Klemmstift (10) oder die mindestens eine Gruppe an Kontakt- und Klemmstiften (10) eine Komponente eines Verbindungselementes (13) ist, welches weiterhin mindestens ein eine Öffnung (23) aufweisendes Dichtmaterial (15) umfasst, wobei der mindestens eine Kontakt- und Klemmstift (10) oder die mindestens eine Gruppe der Kontakt- und Klemmstiften (10) in mindestens einer Öffnung (23) des Dichtmaterials (15) vor der Befestigung auf der Tragplatte (30) angeordnet ist, insbesondere in der Öffnung (23) befestigt ist.

## Claims

1. Electronic plug module (1) comprising a one- or multi-part housing (2), at least one external plug (3) which is fastened to the housing (2) by means of a protective and fastening sleeve (4) or directly, wherein at least one electrically conductive main pin (6) is arranged in the at least one external plug (3) and is electrically conductively connected to an electronic printed circuit board (8), wherein the printed circuit board (8)
comprises a supporting plate (30) and contact and clamping pins (10), and wherein
- the supporting plate (30) is formed from an electrically non-conductive material and comprises electrical conduction tracks and at least one electronic part/component, and wherein the supporting plate (30)
- has at least one hole (20) with at least one adjacent solder connection region (9), and/or
- has at least one solder connection region (9) without a hole (20), wherein
at least one conduction path leads to the at least one solder connection region (9) and this conduction path merges with the solder connection region, wherein the adjacent solder connection region (9) of a hole (20) is designed in particular as an annular or ring-like solder connection region around the hole (20), wherein
- a guide pin (10.1) of a contact and clamping pin (10) having a guide pin (10.1) is inserted into at least one hole (20), or
- a contact and clamping pin (10), which does not have a guide pin (10.1), is mounted onto the solder connection region (9), wherein the contact and clamping pin (10) comprises a plug element in or to which a complementary plug mating element of the main pin (6), such as an end pin (6.1) or an end sleeve of the main pin (6), is fitted, and wherein the at least one contact and clamping pin (10) is soldered on the solder connection region (9) by way of at least one partial surface, wherein, in the printed circuit board (8), the contact and clamping pin (10) at one end
- has a guide pin (10.1) which is at least partially received in the hole (20) and/or
- has a flat bottom side, which rests fully on the solder connection region (9), and wherein the plug element at the opposite end is designed as a clamping element for receiving a main pin (6) or its end pin (6.1).

2. Plug module according to one of the preceding claims, **characterized in that**, in the printed circuit board (8), the outer diameter and/or the shadow area of the clamping bush (10.2) is larger than the outer diameter and/or the shadow area of the guide pin (10.1), as a result of which a soldering and support surface (10.3) is formed beneath the clamping bush (10.2), the contact and clamping pin (10) resting on the supporting plate (30) and being soldered to it by way of soldering and support surface in the solder connection region (9).

3. Plug module according to one of the preceding claims, **characterized in that**, in the printed circuit board (8), the inner surface of the clamping bush (10.2) has at least one cutting or friction element which protrudes inwards.

4. Plug module according to one of the preceding claims, **characterized in that**, in the printed circuit board (8), the clamping sleeve (10.2) has through at least one slot (10.4) which is open to the free end of the clamping sleeve (10.2).

5. Plug module according to one of the preceding claims, **characterized in that** that, in the printed circuit board (8), the hole (20) in the supporting plate (30) is embodied as a blind hole which passes through the supporting plate (30) only on the top side supporting the clamping bush (10.2), wherein the guide pin (10.2) of the contact and clamping pin (10) is fully received in this hole (20), which is embodied as a blind hole, and
wherein in particular the free end (6.1) is glued or potted in the bore (20) at least by way of a partial length.

6. Plug module according to one of the preceding claims, **characterized in that**, in the printed circuit board (8), a sealing element (11) or a sealing ring (12), in particular a glued-on sealing element (11) or sealing ring (12), is arranged around a clamping sleeve (10.2) and/or a group of at least two clamping sleeves (10.2).

7. Plug module according to one of the preceding claims, **characterized in that**, in the printed circuit board (8), the at least one contact and clamping pin (10) or a group of contact and clamping pin (10) is part of a connecting element (13) to which this pin or group of pins is permanently connected, in particular is glued or cast in a force-fitting and/or interlocking manner, and wherein the connecting element (13) comprises a sealing material (15) which surrounds the at least one contact and clamping pin (10) individually or the at least one group of contact and clamping pin (10), and wherein the sealing material (15) comprises at least one opening, in which the at least one contact and clamping pin (10) or the at least one group of contact and clamping pin (10) are arranged.

8. Plug module according to Claim 7, **characterized in that**, in the printed circuit board (8), the contact and clamping pin (10) have support surfaces (10.3), which act as solder surfaces and all support surfaces (10.3) of the contact and clamping pin (10) of a connecting element (13) form a common surface with the bottom side of the respective connecting element (13).

9. Plug module according to either of Claims 7 and 8, **characterized in that**, in the printed circuit board (8), the connecting element (13) is glued onto the supporting plate (30) and/or is connected to the contact and clamping pin (10) via solder connections.

10. Plug module according to one of the preceding claims, **characterized in that** at least one interior space (17) is formed between the supporting plate (30) and the housing (2), the interior space being at least partially filled with a potting material (18).

11. Plug module according to either of Claims 9 and 10, **characterized in that** the protective and fastening sleeve (4) or the external plug (3) has at least one inner stop edge (4.1, 21, 22), which bears against an inner surface of the housing (2).

12. Production method for an electronic plug module according to one of Claims 1 to 11, comprising the steps of:
- providing supporting plates (30) with at least one hole (20) and/or solder connection regions (9) for a contact and clamping pin (10), - mounting and/or inserting at least one contact and clamping pin (10) into the at least one hole (20) and/or the at least one solder connection region (9),
- establishing fastening and electrically conductive connection of the at least one contact and clamping pin (10) to the supporting plate (30), in particular by soldering and
- mounting the supporting plate (30) on at least one main pin (6) of an external plug (3) inserted and held in a housing (2).

13. Production method according to Claim 12, **characterized in that**, before the supporting plate (30) is mounted onto the at least one main pin (6) of an external plug (3) inserted and held in a housing (2), a sealing element (11, 12) is placed around the at least one contact and clamping pin (10) or the at least one group of the contact and clamping pins (10), in particular a sealing element (11) which surrounds both each contact and clamping pin (10) of a group of contact and clamping pins (10) individually and the respective group of contact and clamping pins (10) overall.

14. Production method according to Claim 13, **characterized in that** the at least one contact and clamping pin (10) or the at least one group of contact and clamping pins (10) is a component of a connecting element (13), which further comprises at least one sealing material (15) having an opening (23), wherein the at least one contact and clamping pin (10) or the at least one group of contact and clamping pins (10) is arranged in at least one opening (23) in the sealing material (15), in particular is fastened in the opening (23), before being fastened on the supporting plate (30).

## Revendications

1. Module de connecteur électronique (1) comprenant un boîtier (2) en une ou plusieurs parties, au moins une fiche externe (3) fixée au boîtier (2) au moyen d'une douille de protection et de fixation (4) ou directement, au moins une broche électriquement conductrice principale (6), qui est reliée électriquement à une carte de circuit imprimé électronique (8), étant disposée dans ladite au moins une fiche externe (3), la carte de circuit imprimé (8)
comprenant une plaque de support (30) et des broches de contact et de serrage (10), et
- la plaque de support (30) étant constituée d'un matériau électriquement non conducteur et comprenant des pistes électriquement conductrices et au moins un élément/composant électronique, et la plaque de support (30)
- comportant au moins un alésage (20) présentant au moins une zone de raccordement par brasage adjacente (9) et/ou
- présentant au moins une zone de raccordement par brasage (9) sans alésage (20),
au moins une piste conductrice menant à ladite au moins une zone de raccordement par brasage (9) et cette piste conductrice se raccordant à la zone de raccordement par brasage, la zone de raccordement par brasage adjacente (9) d'un alésage (20) étant en particulier réalisée sous forme de zone de raccordement par brasage annulaire ou en couronne autour de l'alésage (20),
- une broche de guidage (10.1) d'une broche de contact et de serrage (10) qui présente une broche de guidage (10.1) étant insérée dans ledit au moins un alésage (20)
- une broche de contact et de serrage (10) dépourvue de broche de guidage (10.1) étant placée sur la zone de raccordement par brasage (9), la broche de contact et de serrage (10) présentant un élément d'enfichage dans ou sur lequel est fixé un élément d'enfichage complémentaire de la broche principale (6), tel qu'une broche d'extrémité (6.1) ou qu'une douille d'extrémité de la broche principale (6),
et ladite au moins une broche de contact et de serrage (10) étant brasée sur la zone de raccordement par brasage (9) par au moins une surface partielle, la broche de contact et de serrage (10) présentant à une extrémité, dans le cas de la carte de circuit imprimé (8),
- une broche de guidage (10.1) qui est logée au moins partiellement dans l'alésage (20) et/ou
- une face inférieure plate qui s'étend sur toute la surface de la zone de raccordement à braser (9), l'élément d'enfichage étant réalisé à l'extrémité opposée sous forme d'élément de serrage permettant de recevoir une broche principale (6) ou sa broche d'extrémité (6.1).

2. Module de connecteur selon l'une quelconque des revendications précédentes, **caractérisé en ce que**, dans le cas de la carte de circuit imprimé (8), le diamètre extérieur et/ou la surface projetée de la douille de serrage (10.2) est supérieure au diamètre extérieur et/ou à la surface projetée de la broche de guidage (10.1), de sorte qu'une surface de brasage et d'appui (10.3) est formée au-dessous de la douille de serrage (10.2), par laquelle la broche de contact et de serrage (10) repose sur la plaque de support (30) dans la zone de raccordement par brasage (9) et est brasée à celle-ci.

3. Module de connecteur selon l'une quelconque des revendications précédentes, **caractérisé en ce que**, dans le cas de la carte de circuit imprimé (8), la surface intérieure de la douille de serrage (10.2) présente au moins un élément de découpe ou de frottement faisant saillie vers l'intérieur.

4. Module de connecteur selon l'une quelconque des revendications précédentes, **caractérisé en ce que**, dans le cas de la carte de circuit imprimé (8), la douille de serrage (10.2) présente par au moins une fente (10.4) ouverte vers l'extrémité libre de la douille de serrage (10.2).

5. Module de connecteur selon l'une quelconque des revendications précédentes, **caractérisé en ce que**, dans le cas de la carte de circuit imprimé (8), l'alésage (20) présent dans la plaque de support (30) est réalisé sous forme d'alésage borgne qui perce la plaque de support (30) uniquement sur la face supérieure portant la douille de serrage (10.2), la broche de guidage (10.2) de la broche de contact et de serrage (10) étant logée entièrement dans cet alésage (20) réalisé sous forme d'alésage borgne, et
l'extrémité libre (6.1) étant en particulier collée ou coulée dans l'alésage (20) au moins sur une partie de sa longueur.

6. Module de connecteur selon l'une quelconque des revendications précédentes, **caractérisé en ce que**, dans le cas de la carte de circuit imprimé (8), un élément d'étanchéité (11) ou une bague d'étanchéité (12), en particulier un élément d'étanchéité (11) ou une bague d'étanchéité (12) collé(e), est disposé autour d'une douille de serrage (10.2) et/ou d'un groupe d'au moins deux douilles de serrage (10.2).

7. Module de connecteur selon l'une quelconque des revendications précédentes, **caractérisé en ce que**, dans le cas de la carte de circuit imprimé (8), ladite au moins une broche de contact et de serrage (10) ou un groupe de broche de contact et de serrage (10) fait partie d'un élément de liaison (13) auquel elle/il est relié(e) de manière fixe, en particulier par complémentarité de force et/ou de forme, collé ou encapsulé, et l'élément de liaison (13) comprenant un matériau d'étanchéité (15) qui entoure ladite au moins une broche de contact et de serrage (10) de manière individuelle ou ledit au moins un groupe de broche de contact et de serrage (10), et le matériau d'étanchéité (15) comprenant au moins une ouverture dans laquelle sont disposés ladite au moins une broche de contact et de serrage (10) ou ledit au moins un groupe de broche de contact et de serrage (10).

8. Module de connecteur selon la revendication 7, **caractérisé en ce que**, dans le cas de la carte de circuit imprimé (8), les broche de contact et de serrage (10) présentent des surfaces d'appui (10.3) qui servent de surfaces de brasage et toutes les surfaces d'appui (10.3) des broche de contact et de serrage (10) d'un élément de liaison (13) forment une surface commune avec la face inférieure de l'élément de liaison (13) respectif.

9. Module de connecteur selon l'une quelconque des revendications 7 ou 8, **caractérisé en ce que**, dans le cas de la carte de circuit imprimé (8), l'élément de liaison (13) est collé à la plaque de support (30) et/ou la broche de contact et de serrage (10) est reliée par l'intermédiaire de liaisons brasées.

10. Module de connecteur selon l'une quelconque des revendications précédentes, **caractérisé en ce que**, entre la plaque de support (30) et le boîtier (2), est formé au moins un espace intérieur (17) rempli au moins en partie d'un matériau de coulée (18).

11. Module de connecteur selon l'une quelconque des revendications 9 ou 10, **caractérisé en ce que** la douille de protection et de fixation (4) ou la fiche externe (3) présente au moins une arête de butée intérieure (4.1, 21, 22) qui repose sur une surface intérieure du boîtier (2).

12. Procédé de fabrication d'un module de connecteur électronique selon l'une quelconque des revendications 1 à 11, comprenant les étapes suivantes :
- fourniture de plaques de support (30) présentant au moins un alésage (20) et/ou des zones de raccordement par brasage (9) pour une broche de contact et de serrage (10), - mise en place et/ou insertion d'au moins une broche de contact et de serrage (10) dans ledit au moins un alésage (20) et/ou ladite au moins une zone de raccordement par brasage (9),
- réalisation d'une fixation et d'une liaison électriquement conductrice de ladite au moins une broche de contact et de serrage (10) à la plaque de support (30), en particulier par brasage, et
- enfichage de la plaque de support (30) sur au moins une broche principale (6) d'une fiche externe (3) insérée et maintenue dans un boîtier (2).

13. Procédé de fabrication selon la revendication 12, **caractérisé en ce qu'**avant l'enfichage de la plaque de support (30) sur ladite au moins une broche principale (6) d'une fiche externe (3) insérée et maintenue dans un boîtier (2), un élément d'étanchéité (11, 12) est placé autour de ladite au moins une broche de contact et de serrage (10) ou dudit au moins un groupe de broches de contact et de serrage (10), en particulier un élément d'étanchéité (11) qui entoure aussi bien chaque broche de contact et de serrage (10) d'un groupe de broches de contact et de serrage (10) de manière individuelle, que le groupe de broches de contact et de serrage (10) respectif dans son ensemble.

14. Procédé de fabrication selon la revendication 13, **caractérisé en ce que** ladite au moins une broche de contact et de serrage (10) ou ledit au moins un groupe de broches de contact et de serrage (10) fait partie d'un élément de liaison (13) qui comprend en outre au moins un matériau d'étanchéité (15) présentant une ouverture (23), ladite au moins une broche de contact et de serrage (10) ou ledit au moins un groupe de broches de contact et de serrage (10) étant disposés dans au moins une ouverture (23) du matériau d'étanchéité (15) avant la fixation à la plaque de support (30), en particulier dans l'ouverture (23).
